# EUROPÄISCHE PATENTSCHRIFT

(11) **EP 3 053 192 B1**
(45) Veröffentlichungstag und Bekanntmachung des Hinweises auf die Patenterteilung: **13.05.2020**
(21) Anmeldenummer: 14776860.0
(22) Anmeldetag: 26.09.2014
(51) Int. Cl.: H01L 23/31, H01L 23/373, H01L 23/495, H01L 23/49, H01L 25/16, H05K 1/14

(54) **SCHALTUNGSVORRICHTUNG UND VERFAHREN ZU DEREN HERSTELLUNG**
CIRCUIT DEVICE AND METHOD FOR THE PRODUCTION THEREOF
DISPOSITIF AVEC UN CIRCUIT ET PROCÉDÉ DE FABRICATION DU DISPOSITIF

(30) Priorität: 02.10.2013 DE 102013219992
(43) Veröffentlichungstag der Anmeldung: 10.08.2016
(73) Patentinhaber: Conti Temic Microelectronic GmbH, 90411 Nürnberg (DE)
(72) Erfinder: STEINAU, Martin, 90489 Nürnberg (DE); SCHMIDT, Thomas, 93133 Burglengenfeld (DE); SCHUCH, Bernhard, 91616 Neusitz (DE)
(74) Vertreter: Bonn, Roman Klemens
(86) Internationale Anmeldenummer: PCT/EP2014/070652
(87) Internationale Veröffentlichungsnummer: WO 2015/049178

(56) Entgegenhaltungen:
- WO-A1-95/11523
- WO-A2-03/085738
- DE-A1-102007 032 142
- US-A- 5 754 403
- US-A- 6 028 770
- US-A1- 2004 212 965
- US-A1- 2005 272 252
- US-A1- 2006 065 421
- US-A1- 2010 059 886
- US-A1- 2010 102 438

## Beschreibung

Die Erfindung betrifft eine Schaltungsvorrichtung und ein Verfahren zu deren Herstellung, wobei die Schaltungsvorrichtung zwei in einem Gehäuse eingebettete Substrate aufweist.

Eine derartige Schaltungsvorrichtung ist aus WO 2009/003791 A1 bekannt. Dort wird ein Elektronikmodul mit einem mindestens ein elektronisches Bauelement aufweisenden ersten Substrat und einem das Substrat einbettenden, als Spritzgussgehäuse oder Spritzpressgehäuse ausgebildeten Gehäuse offenbart, wobei im Gehäuse mindestens ein weiteres Substrat eingebettet ist.

US 2010/102438 A1 offenbart eine Halbleitervorrichtung mit einem Substrat, einem Halbleiterchip, einer Versiegleung und einer Dichtung. Das Substrat weist eine erste Oberfläche und eine zweite Oberfläche auf, wobei die erste Oberfläche einen ersten und einen zweiten Bereich umfasst. Der Halbleiterchip bedeckt den ersten Bereich. Die Versiegelung bedeckt den zweiten Bereich und den Halbleiterchip. Die Dichtung bedeckt die zweite Oberfläche.

US 2005/272252 A1 offenbart eine Schaltungsvorrichtung, die ein hauptsächlich aus Metall bestehendes Substrat aufweist. Das Substrat umfasst eine erste Metallschicht mit einem ersten Wärmeausdehnungskoeffizienten, eine auf der ersten Metallschicht ausgebildete zweite Metallschicht mit einem von dem ersten Wärmeausdehnungskoeffizienten verschiedenen zweiten Wärmeausdehnungskoeffizienten, und eine dritte Metallschicht, die auf der zweiten Metallschicht ausgebildet ist und einen von dem zweiten Wärmeausdehnungskoeffizienten verschiedenen dritten Wärmeausdehnungskoeffizienten aufweist. Die Schaltungsvorrichtung umfasst ferner eine auf dem Substrat ausgebildete Isolierschicht, eine auf der Isolierschicht ausgebildete leitende Schicht und ein Schaltungselement, das elektrisch mit der leitenden Schicht verbunden ist.

US 2004/212965 A1 offenbart eine harzversiegelte elektronische Schaltungsvorrichtung, die mindestens zwei Leiterplatten umfasst, auf denen elektronische Komponenten montiert sind. Die Leiterplatten sind über einen Klebstoff an einem Kühlkörper mit hoher Wärmeleitfähigkeit befestigt. Die Gesamtheit der Leiterplatten und des Kühlkörpers sowie ein Teil eines externen Verbindungsanschlusses sind hermetisch abgedichtet und in eine Harzzusammensetzung eingegossen.

US 5 754 403 A offenbart einen Wärmekern mit einer Aluminiumschicht, die zwischen zwei Molybdänschichten angeordnet ist, um Wärme von einer Vielzahl von Chipträgern abzuleiten.

Der Erfindung liegt die Aufgabe zu Grunde, eine verbesserte Schaltungsvorrichtung mit zwei in einem Gehäuse eingebetteten Substraten anzugeben. Ferner liegt der Erfindung die Aufgabe zu Grunde, ein Verfahren zu deren Herstellung anzugeben.

Die Aufgabe wird erfindungsgemäß hinsichtlich der Vorrichtung durch die Merkmale des Anspruchs 1 und hinsichtlich des Verfahrens durch die Merkmale des Anspruchs 10 gelöst.

Vorteilhafte Ausgestaltungen der Erfindung sind Gegenstand der Unteransprüche.

Eine erfindungsgemäße Schaltungsvorrichtung umfasst eine Grundplatte, ein an einer ersten Außenseite der Grundplatte angeordnetes erstes Substrat, ein an einer der ersten Außenseite gegenüberliegenden zweiten Außenseite der Grundplatte angeordnetes zweites Substrat, wenigstens ein das erste Substrat und das zweite Substrat elektrisch verbindendes elektrisches Verbindungselement, wenigstens ein auf oder in dem ersten Substrat angeordnetes elektronisches Bauelement, wenigstens ein auf oder in dem zweiten Substrat angeordnetes elektronisches Bauelement, ein um die beiden Substrate und die auf ihnen angeordneten elektronischen Bauelemente herumgegossenes Mouldgehäuse, und wenigstens ein mit dem ersten Substrat und/oder dem zweiten Substrat elektrisch leitfähig verbundenes und aus dem Mouldgehäuse herausgeführtes Kontaktierungselement zur elektrischen Kontaktierung des ersten und/oder zweiten Substrates.

Die erfindungsgemäße Schaltungsvorrichtung ermöglicht, zwei unterschiedliche Substrate in einem gemeinsamen Mouldgehäuse zu integrieren, so dass vorteilhaft die Substrate durch das Mouldgehäuse geschützt und gekapselt werden, wobei von auf oder in den Substraten angeordneten elektronischen Bauelementen erzeugte Wärme durch das Mouldgehäuse abgeführt werden kann. Durch das wenigstens eine aus dem Mouldgehäuse herausgeführte Kontaktierungselement können die Substrate vorteilhaft außerhalb des Mouldgehäuses elektrisch kontaktiert werden. Dabei ist die Schaltungsvorrichtung vorteilhaft durch ihren kompakten Aufbau bauraumsparend ausgeführt und kann wegen des Mouldgehäuses und des wenigstens einen aus dem Mouldgehäuse herausgeführten Kontaktierungselement wie ein Stecker eingesetzt werden. Außerdem können durch Verwendung gleichartiger Mouldgehäuse verschiedene Schaltungsvorrichtungen mit ähnlichem oder gleichem Design hergestellt werden.

Eine Ausgestaltung der Erfindung sieht vor, dass wenigstens eines der beiden Substrate als ein Mikroelektronikmodul, das auf einer Bare Die-High-Density-Interconnect-Leiterplatte oder einem Keramiksubstrat oder einem Niedertemperatur-Einbrand-Keramiksubstrat oder einem Hochtemperatur-Mehrlagenkeramiksubstrat aufgebaut ist, oder als ein Leistungselektronikmodul ausgebildet ist, wobei das Leistungselektronikmodul beispielsweise auf einem DCB-Substrat (DCB = Direct Bonded Copper) oder einem anderen leistungselektronikfähigen Substrat basiert.

Dadurch können vorteilhaft Mikroelektronikmodule und/oder Leistungselektronikmodule erfindungsgemäß in einem Mouldgehäuse integriert werden.

Eine weitere Ausgestaltung der Erfindung sieht ein als Bonddraht, flexible Leiterplatte (z.B. als Polyimid Flexfolie), temperaturbeständige thermoplastische Leiterplatte oder Stanzgitter ausgebildetes elektrisches Verbindungselement vor.

Derartige elektrische Verbindungselemente eignen sich besonders vorteilhaft zur Herstellung einer erfindungsgemäßen Schaltungsvorrichtung, da ihre Form durch ihre Deformierbarkeit den räumlichen Gegebenheiten angepasst werden kann und die Substrate einfach in der erforderlichen Weise zueinander angeordnet werden können.

Eine weitere Ausgestaltung der Erfindung sieht vor, dass wenigstens ein Substrat an der Grundplatte durch Kleben oder Laminieren befestigt ist.

Dadurch können die Substrate durch Fixierung an der Grundplatte korrekt und dauerhaft positioniert werden.

Eine weitere Ausgestaltung der Erfindung sieht vor, dass beide Substrate gegenüber der Grundplatte elektrisch isoliert sind.

Dies verhindert vorteilhaft Kurzschlüsse in der Schaltungsvorrichtung.

Eine weitere Ausgestaltung der Erfindung sieht vor, dass die Grundplatte wenigstens teilweise aus Metall, Keramik, Polymer oder Verbundwerkstoffen gefertigt ist.

Derartige Materialien eignen sich besonders vorteilhaft zur Herstellung stabiler Grundplatten mit erfindungsgemäß vorgesehenen Eigenschaften.

Die Erfindung sieht ferner vor, dass die Grundplatte mehrere übereinander angeordnete Schichten unterschiedlicher thermischer Ausdehnungskoeffizienten oder Wärmeleitfähigkeiten aufweist. Dabei bildet eine Außenseite einer ersten Schicht die erste Außenseite der Grundplatte und eine Außenseite einer zweiten Schicht bildet die zweite Außenseite der Grundplatte. Die Schichten sind in einer ihren thermischen Ausdehnungskoeffizienten oder Wärmeleitfähigkeiten entsprechenden Reihenfolge übereinander angeordnet, wobei der thermische Ausdehnungskoeffizient oder die Wärmeleitfähigkeit der ersten Schicht am besten mit dem thermischen Ausdehnungskoeffizienten oder der Wärmeleitfähigkeit des ersten Substrates übereinstimmt und der thermische Ausdehnungskoeffizient oder die Wärmeleitfähigkeit der zweiten Schicht am besten mit dem thermischen Ausdehnungskoeffizienten oder der Wärmeleitfähigkeit des zweiten Substrates übereinstimmt.

Dadurch werden vorteilhaft unterschiedliche thermische Ausdehnungskoeffizienten oder Wärmeleitfähigkeiten der beiden Substrate ausgeglichen und damit die Funktionalität und Stabilität der Schaltungsvorrichtung bei Temperaturänderungen verbessert.

Eine weitere Ausgestaltung der Erfindung sieht vor, dass das Mouldgehäuse aus Polymeren und aus anorganischen Partikeln, die jeweils aus wenigstens einem Metalloxid und/oder Metallnitrid und/oder Metallcarbid und/oder Halbmetalloxid und/oder Halbmetallnitrid und/oder Halbmetallcarbid bestehen, gefertigt ist. Die Polymere sind bevorzugt aus der Gruppe der Epoxide, können aber auch auf anderen thermoplastischen, duroplastischen oder elastomeren Kunststoffen basieren.

Derartige Mouldgehäuse weisen eine hohe Wärmeleitfähigkeit auf und eignen sich daher besonders vorteilhaft zur Abführung von Wärme aus der Schaltungsvorrichtung.

Eine weitere Ausgestaltung der Erfindung sieht vor, dass die Grundplatte aus dem Mouldgehäuse herausragt.

Dadurch kann vorteilhaft auch durch die Grundplatte Wärme aus der Schaltungsvorrichtung abgeführt werden.

Eine weitere Ausgestaltung der Erfindung sieht ein als ein Stanzgitter, flexible Leiterplatte oder temperaturbeständige thermoplastische Leiterplatte ausgebildetes Kontaktierungselement vor. Ein als Stanzgitter ausgebildetes Kontaktierungselement ist dabei beispielsweise durch Schweißen, Löten, Bonden, Sintern, Sinterkleben oder Kleben mit den Substraten elektrisch leitend verbunden.

Derartige Kontaktierungselemente eignen sich besonders gut zur Verwendung in einer Schaltungsvorrichtung, da sie verformbar und damit den räumlichen Erfordernissen anpassbar ist.

Eine weitere Ausgestaltung der Erfindung sieht vor, dass das Mouldgehäuse im Bereich des ersten Substrates aus einem ersten Material, dessen thermischer Ausdehnungskoeffizient dem thermischen Ausdehnungskoeffizienten des ersten Substrates angepasst ist, und im Bereich des zweiten Substrates aus einem zweiten Material, dessen thermischer Ausdehnungskoeffizient dem thermischen Ausdehnungskoeffizienten des zweiten Substrates angepasst ist, gefertigt ist.

Dadurch wird das Mouldgehäuse vorteilhaft den unterschiedlichen thermischen Ausdehnungskoeffizienten der beiden Substrate angepasst und damit die Funktionalität und Stabilität der Schaltungsvorrichtung bei Temperaturänderungen verbessert.

Bei einem erfindungsgemäßen Verfahren zur Herstellung einer erfindungsgemäßen Schaltungsvorrichtung werden das erste Substrat und das zweite Substrat durch das wenigstens eine elektrische Verbindungselement elektrisch miteinander verbunden, das erste Substrat und/oder das zweite Substrat elektrisch leitfähig mit dem wenigstens einen Kontaktierungselement verbunden, und auf oder in dem ersten Substrat und auf oder in dem zweiten Substrat jeweils wenigstens ein elektronisches Bauelement angeordnet. Das erste Substrat wird an der ersten Außenseite der Grundplatte angeordnet und das zweite Substrat wird an der zweiten Außenseite der Grundplatte angeordnet und um die beiden Substrate und die auf ihnen angeordneten elektronischen Bauelemente herum wird das Mouldgehäuse gegossen. Das Mouldgehäuse wird durch Transferpressen, Compression Moulding, Spritzguss oder Sheetmoulding oder durch drucklosen Verguss hergestellt.

Das Verfahren ermöglicht es, eine Schaltungsvorrichtung mit den oben genannten Vorteilen herzustellen.

Ausführungsbeispiele der Erfindung werden im Folgenden anhand von Zeichnungen näher erläutert.

Darin zeigen:
- Figur 1: schematisch eine Grundplatte mit zwei an ihr angeordneten und elektrisch miteinander verbundenen Substraten in einer Schnittdarstellung mit einer durch die Grundplatte und die Substrate verlaufenden Schnittebene,
- Figur 2: schematisch ein erstes Ausführungsbeispiel einer Schaltungsvorrichtung in einer Schnittdarstellung mit einer durch die Grundplatte und die Substrate verlaufenden Schnittebene,
- Figur 3: schematisch das erste Ausführungsbeispiel einer Schaltungsvorrichtung in einer Schnittdarstellung mit einer auf einem Substrat verlaufenden Schnittebene,
- Figur 4: schematisch ein zweites Ausführungsbeispiel einer Schaltungsvorrichtung in einer Schnittdarstellung mit einer durch die Grundplatte und die Substrate verlaufenden Schnittebene,
- Figur 5: schematisch Komponenten einer Schaltungsvorrichtung nach einem ersten Verfahrensschritt eines Verfahrens zu dessen Herstellung,
- Figur 6: schematisch Komponenten einer Schaltungsvorrichtung nach einem zweiten Verfahrensschritt eines Verfahrens zu dessen Herstellung,
- Figur 7: schematisch Komponenten einer Schaltungsvorrichtung nach einem dritten Verfahrensschritt eines Verfahrens zu dessen Herstellung,
- Figur 8: schematisch Komponenten einer Schaltungsvorrichtung nach einem vierten Verfahrensschritt eines Verfahrens zu dessen Herstellung,
- Figur 9: schematisch Komponenten einer Schaltungsvorrichtung nach einem fünften Verfahrensschritt eines Verfahrens zu dessen Herstellung, und
- Figur 10: schematisch eine Schaltungsvorrichtung nach einem sechsten Verfahrensschritt eines Verfahrens zu dessen Herstellung.

Einander entsprechende Teile sind in allen Figuren mit den gleichen Bezugszeichen versehen.

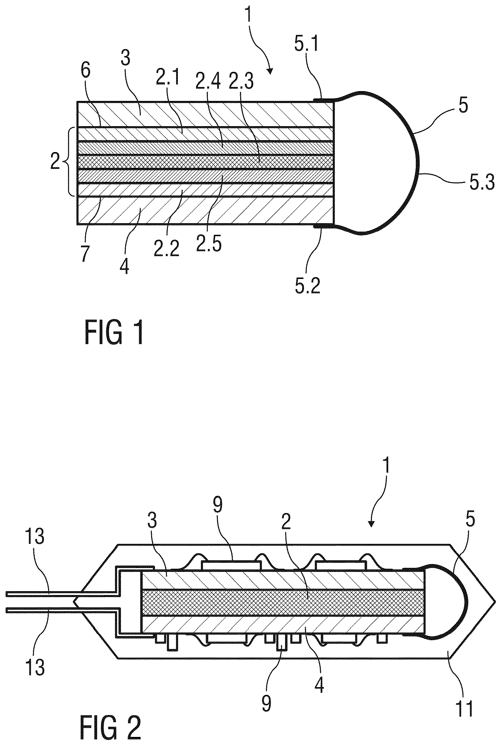

Figur 1 zeigt schematisch eine Grundplatte 2, ein erstes Substrat 3, ein zweites Substrat 4 und ein elektrisches Verbindungselement 5 einer nur teilweise dargestellten Schaltungsvorrichtung 1.

Das erste Substrat 3 ist an einer ersten Außenseite 6 der Grundplatte 2 angeordnet. Das zweite Substrat 4 ist an einer der ersten Außenseite 6 gegenüberliegenden zweiten Außenseite 7 der Grundplatte 2 angeordnet.

Das elektrische Verbindungselement 5 ist als eine flexible Leiterplatte, z.B. als eine Polyimid Flexfolie, oder als ein Bonddraht ausgebildet. Ein erster Endabschnitt 5.1 des elektrischen Verbindungselementes 5 ist elektrisch mit dem ersten Substrat 3 verbunden. Ein zweiter Endabschnitt 5.2 des elektrischen Verbindungselementes 5 ist elektrisch mit dem zweiten Substrat 4 verbunden. Ein Mittelbereich 5.3 des elektrischen Verbindungselementes 5 ist außen um Enden der Grundplatte 2 und der Substrate 3, 4 herumgeführt.

Die Grundplatte 2 besteht aus fünf übereinander angeordneten Schichten 2.1 bis 2.5, die voneinander unterschiedliche thermische Ausdehnungskoeffizienten aufweisen. Dabei bildet eine Außenseite einer ersten Schicht 2.1 die erste Außenseite 6 der Grundplatte 2. Die erste Schicht 2.1 weist einen thermischen Ausdehnungskoeffizienten auf, der mit dem thermischen Ausdehnungskoeffizienten des ersten Substrates 3 übereinstimmt. Eine Außenseite einer zweiten Schicht 2.2 bildet die zweite Außenseite 7 der Grundplatte 2. Die zweite Schicht 2.2 weist einen thermischen Ausdehnungskoeffizienten auf, der mit dem thermischen Ausdehnungskoeffizienten des zweiten Substrates 4 übereinstimmt. Die weiteren Schichten 2.3, 2.4, 2.5 sind zwischen der ersten Schicht 2.1 und der zweiten Schicht 2.2 angeordnet und weisen thermische Ausdehnungskoeffizienten auf, die zwischen den thermischen Ausdehnungskoeffizienten der ersten Schicht 2.1 und der zweiten Schicht 2.2 liegen. Dabei sind die Schichten 2.1 bis 2.5 in der Reihenfolge ihrer thermischen Ausdehnungskoeffizienten angeordnet, d.h. die thermischen Ausdehnungskoeffizienten der Schichten 2.1 bis 2.5 nehmen von der ersten Schicht 2.1 bis zur zweiten Schicht 2.5 monoton ab, wenn der thermische Ausdehnungskoeffizient des ersten Substrats 3 größer als der thermische Ausdehnungskoeffizient des zweiten Substrats 4 ist, oder monoton zu, wenn der thermische Ausdehnungskoeffizient des ersten Substrats 3 kleiner als der thermische Ausdehnungskoeffizient des zweiten Substrats 4 ist. Beispielsweise weist eine mittlere dritte Schicht 2.3 einen thermischen Ausdehnungskoeffizienten auf, der ein Mittelwert der thermischen Ausdehnungskoeffizienten der ersten Schicht 2.1 und der zweiten Schicht 2.2 ist, eine zwischen der ersten Schicht 2.1 und der dritten Schicht 2.3 angeordnete vierte Schicht 2.4 weist einen thermischen Ausdehnungskoeffizienten auf, der ein Mittelwert der thermischen Ausdehnungskoeffizienten der ersten Schicht 2.1 und der dritten Schicht 2.3 ist, und eine zwischen der zweiten Schicht 2.2 und der dritten Schicht 2.3 angeordnete fünfte Schicht 2.5 weist einen thermischen Ausdehnungskoeffizienten auf, der ein Mittelwert der thermischen Ausdehnungskoeffizienten der zweiten Schicht 2.2 und der dritten Schicht 2.3 ist.

In alternativen Ausführungsbeispielen kann die Grundplatte 2 eine andere Anzahl von Schichten 2.1 bis 2.5 aufweisen, die voneinander unterschiedliche thermische Ausdehnungskoeffizienten aufweisen und analog entsprechend ihrer thermischen Ausdehnungskoeffizienten und der thermischen Ausdehnungskoeffizienten der Substrate 3, 4 ausgewählt und übereinander angeordnet sind. Ferner können die Schichten 2.1 bis 2.5 auch entsprechend ihrer Wärmeleitfähigkeiten statt ihrer thermischen Ausdehnungskoeffizienten und der Wärmeleitfähigkeiten der Substrate 3, 4 ausgewählt und übereinander angeordnet sein.

Ferner können an der ersten Außenseite 6 und/oder an der zweiten Außenseite 7 der Grundplatte 2 auch mehrere Substrate 3, 4 angeordnet sein und/oder es können elektrisch nicht miteinander verbundene Schaltungen auf der Grundplatte 2 positioniert sein.

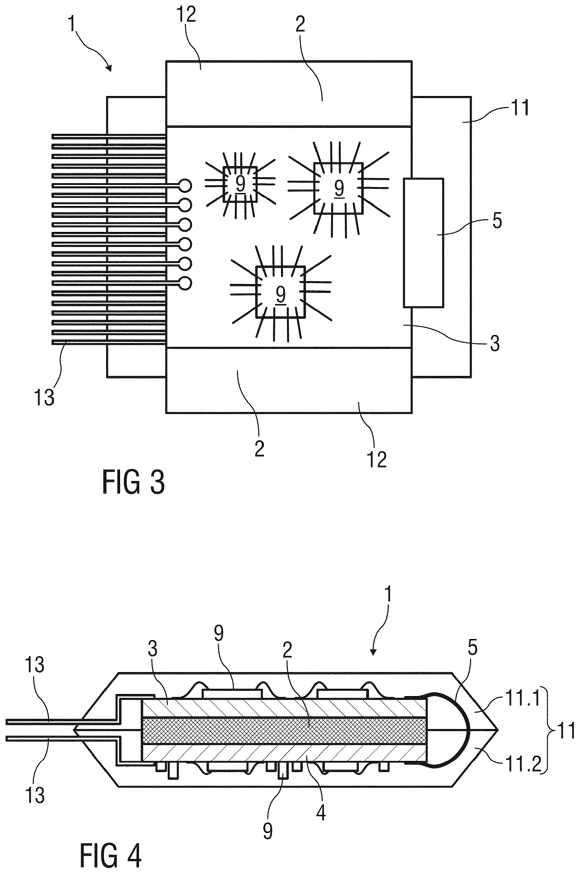

Die Figuren 2 und 3 zeigen schematisch Schnittdarstellungen eines ersten Ausführungsbeispiels einer Schaltungsvorrichtung 1 mit einer Grundplatte 2, Substraten 3, 4 und einem elektrischen Verbindungselement 5 wie in Figur 1. Dabei zeigt Figur 2 eine Schnittdarstellung mit einer durch die Grundplatte 2 und die Substrate 3, 4 verlaufenden Schnittebene, und Figur 3 zeigt eine Schnittdarstellung mit einer auf dem ersten Substrat 3 verlaufenden Schnittebene.

Auf den von der Grundplatte 2 abgewandten Außenseiten der Substrate 3, 4 sind jeweils elektronische Bauelemente 9 angeordnet.

Um die beiden Substrate 3, 4 und die auf ihnen angeordneten elektronischen Bauelemente 9 herum ist ein Mouldgehäuse 11 gegossen. Das Mouldgehäuse 11 besteht aus Polymeren sowie als Füllstoff aus anorganischen Partikeln, die jeweils aus wenigstens einem Metalloxid und/oder Metallnitrid und/oder Metallcarbid und/oder Halbmetalloxid und/oder Halbmetallnitrid und/oder Halbmetallcarbid bestehen. Die Polymere sind bevorzugt aus der Gruppe der Epoxide, können aber auch auf anderen thermoplastischen, duroplastischen oder elastomeren Kunststoffen basieren.

Das erste Substrat 3 und das zweite Substrat 4 sind jeweils elektrisch leitfähig mit einem als ein Drahtgitter ausgebildeten Kontaktierungselement 13, das aus dem Mouldgehäuse 11 zur elektrischen Kontaktierung der Substrate 3, 4 herausgeführt ist, verbunden. Dabei ist das Kontaktierungselement 13 beispielsweise durch Schweißen, Löten, Bonden, Sintern, Sinterkleben oder Kleben mit den Substraten elektrisch leitend verbunden. Seitenbereiche 12 der Grundplatte 2 ragen zur Wärmeabführung aus dem Mouldgehäuse 11 heraus.

Figur 4 zeigt schematisch ein zweites Ausführungsbeispiel einer Schaltungsvorrichtung 1 in einer zu Figur 2 analogen Schnittdarstellung. Dieses Ausführungsbeispiel unterscheidet sich von dem in Figur 2 dargestellten Ausführungsbeispiel dadurch, dass das Mouldgehäuse 11 im Bereich des ersten Substrates 3 aus einem ersten Material 11.1, dessen thermischer Ausdehnungskoeffizient dem thermischen Ausdehnungskoeffizienten des ersten Substrates 3 angepasst ist, und im Bereich des zweiten Substrates 4 aus einem zweiten Material 11.2, dessen thermischer Ausdehnungskoeffizient dem thermischen Ausdehnungskoeffizienten des zweiten Substrates 4 angepasst ist, gefertigt ist.

Das erste Material 11.1 und das zweite Material 11.2 des Mouldgehäuses 11 unterscheiden sich dabei voneinander durch die Art und/oder die Menge des Füllstoffes und/oder einer unterschiedlichen Zusammensetzung der Polymere und/oder Füllstoffe.

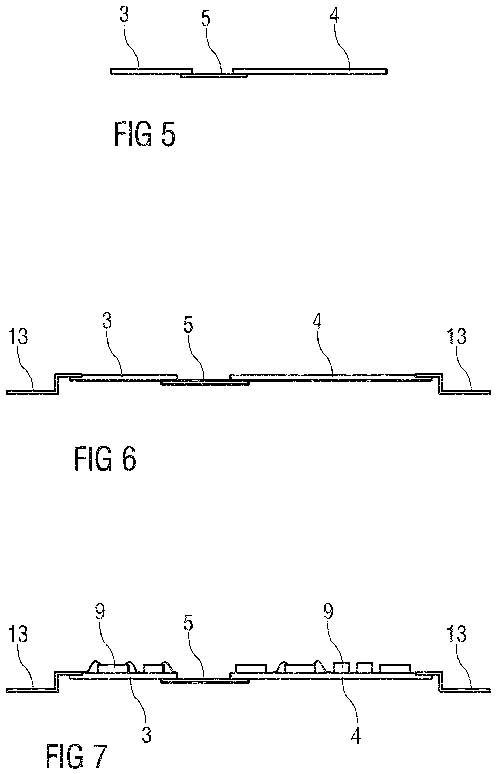

Die Figuren 5 bis 10 zeigen jeweils Komponenten einer Schaltungsvorrichtung 1 nach aufeinander folgenden Verfahrensschritten eines Verfahrens zur Herstellung der Schaltungsvorrichtung 1.

In einem ersten Verfahrensschritt werden gemäß Figur 5 das erste Substrat 3 und das zweite Substrat 4 durch wenigstens ein elektrisches Verbindungselement 5 miteinander verbunden.

In einem zweiten Verfahrensschritt werden gemäß Figur 6 das erste Substrat 3 und das zweite Substrat 4 jeweils mit wenigstens einem Kontaktierungselement 13, beispielsweise mit einem Stanzgitter, elektrisch leitfähig verbunden.

In einem dritten Verfahrensschritt werden gemäß Figur 7 das erste Substrat 3 und das zweite Substrat 4 jeweils mit elektronischen Bauelementen 9 bestückt.

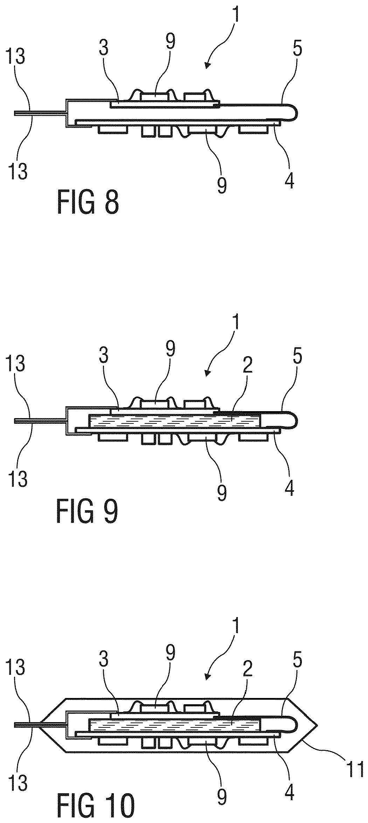

In einem vierten Verfahrensschritt wird gemäß Figur 8 das wenigstens eine elektrische Verbindungselement 5 umgebogen.

In einem fünften Verfahrensschritt wird gemäß Figur 9 die Grundplatte 2 zwischen die Substrate 3, 4 eingebracht und die Substrate 3, 4 werden an der Grundplatte 2 befestigt.

In einem sechsten Verfahrensschritt wird gemäß Figur 10 das Mouldgehäuse 11 um die beiden Substrate 3, 4 und die auf ihnen angeordneten elektronischen Bauelemente 9 gegossen.

Der erste bis fünfte Verfahrensschritt können dabei auch in jeder beliebigen anderen Reihenfolge ausgeführt werden, und einzelne Verfahrensschritte können gegebenenfalls wegfallen.

Im Falle, dass das Mouldgehäuse 11 wie im in Figur 4 gezeigten Ausführungsbeispiel zwei Bereiche aufweist, die aus unterschiedlichen Materialien 11.1, 11.2 gefertigt sind, erfolgt eine Einspritzung der beiden unterschiedlichen Materialien 11.1, 11.2 beispielsweise durch zwei Kanäle, die oberhalb und unterhalb einer Formtrennung angebracht sind. Durch eine gemeinsame Einspritzung erfolgt an einer Grenzfläche der beiden Materialien 11.1, 11.2 eine leichte Verwirbelung, wodurch es zu einer guten Anbindung der beiden Materialien 11.1, 11.2 kommt. Alternativ erfolgt eine Umspritzung mit den beiden Materialien 11.1, 11.2 in zwei aufeinander folgenden Verfahrensschritten.

### BEZUGSZEICHENLISTE

- 1: Schaltungsvorrichtung
- 2: Grundplatte
- 2.1 bis 2.5: Schicht
- 3: erstes Substrat
- 4: zweites Substrat
- 5: elektrisches Verbindungselement
- 5.1: erster Endabschnitt
- 5.2: zweiter Endabschnitt
- 5.3: Mittelbereich
- 6: erste Außenseite
- 7: zweite Außenseite
- 9: elektronisches Bauelement
- 11: Mouldgehäuse
- 11.1: erstes Material
- 11.2: zweites Material
- 12: Seitenbereich
- 13: Kontaktierungselement

## Patentansprüche

1. Schaltungsvorrichtung (1) umfassend
- eine Grundplatte (2),
- ein an einer ersten Außenseite (6) der Grundplatte (2) angeordnetes erstes Substrat (3),
- ein an einer der ersten Außenseite (6) gegenüberliegenden zweiten Außenseite (7) der Grundplatte (2) angeordnetes zweites Substrat (4),
- wenigstens ein das erste Substrat (3) und das zweite Substrat (4) elektrisch verbindendes elektrisches Verbindungselement (5),
- wenigstens ein auf oder in dem ersten Substrat (3) angeordnetes elektronisches Bauelement (9),
- wenigstens ein auf oder in dem zweiten Substrat (4) angeordnetes elektronisches Bauelement (9),
- ein um die beiden Substrate (3, 4) und die auf ihnen angeordneten elektronischen Bauelemente (9) herumgegossenes Mouldgehäuse (11),
- und wenigstens ein mit dem ersten Substrat (3) und/oder dem zweiten Substrat (4) elektrisch leitfähig verbundenes und aus dem Mouldgehäuse (11) herausgeführtes Kontaktierungselement (13) zur elektrischen Kontaktierung des ersten Substrates (3) und/oder zweiten Substrates (4),
**dadurch gekennzeichnet, dass**
- das Mouldgehäuse (11) im Bereich des ersten Substrates (3) aus einem ersten Material (11.1), dessen thermischer Ausdehnungskoeffizient dem thermischen Ausdehnungskoeffizienten des ersten Substrates (3) angepasst ist, und im Bereich des zweiten Substrates (4) aus einem zweiten Material (11.2), dessen thermischer Ausdehnungskoeffizient dem thermischen Ausdehnungskoeffizienten des zweiten Substrates (4) angepasst ist, gefertigt ist,
- und dass die Grundplatte (2) mindestens drei übereinander angeordnete Schichten (2.1 bis 2.5) unterschiedlicher thermischer Ausdehnungskoeffizienten aufweist, wobei die erste Außenseite (6) der Grundplatte (2) von einer Außenseite einer ersten Schicht (2.1) gebildet wird und die zweite Außenseite (7) der Grundplatte (2) von einer Außenseite einer zweiten Schicht (2.2) gebildet wird und die thermischen Ausdehnungskoeffizienten der mindestens drei Schichten (2.1 bis 2.5) von der ersten Schicht (2.1) bis zur zweiten Schicht (2.2) monoton abnehmen, wenn der thermische Ausdehnungskoeffizient des ersten Substrats (3) größer als der thermische Ausdehnungskoeffizient des zweiten Substrats (4) ist, oder monoton zunehmen, wenn der thermische Ausdehnungskoeffizient des ersten Substrats (3) kleiner als der thermische Ausdehnungskoeffizient des zweiten Substrats (4) ist, und wobei der thermische Ausdehnungskoeffizient der ersten Schicht (2.1) mit dem thermischen Ausdehnungskoeffizienten des ersten Substrates (3) übereinstimmt und der thermische Ausdehnungskoeffizient der zweiten Schicht (2.2) mit dem thermischen Ausdehnungskoeffizienten des zweiten Substrates (4) übereinstimmt.

2. Schaltungsvorrichtung (1) nach Anspruch 1,
**dadurch gekennzeichnet, dass** wenigstens eines der beiden Substrate (3, 4) als ein Mikroelektronikmodul, das auf einer Bare Die-High-Density-Interconnect-Leiterplatte oder einem Keramiksubstrat oder einem Niedertemperatur-Einbrand-Keramiksubstrat oder einem Hochtemperatur-Mehrlagenkeramiksubstrat aufgebaut ist, oder als ein Leistungselektronikmodul ausgebildet ist.

3. Schaltungsvorrichtung (1) nach einem der vorhergehenden Ansprüche, **gekennzeichnet durch** ein als Bonddraht, flexible Leiterplatte, temperaturbeständige thermoplastische Leiterplatte oder Stanzgitter ausgebildetes elektrisches Verbindungselement (5).

4. Schaltungsvorrichtung (1) nach einem der vorhergehenden Ansprüche,
**dadurch gekennzeichnet, dass** wenigstens ein Substrat (3, 4) an der Grundplatte (2) durch Kleben oder Laminieren befestigt ist.

5. Schaltungsvorrichtung (1) nach einem der vorhergehenden Ansprüche,
**dadurch gekennzeichnet, dass** beide Substrate (3, 4) gegenüber der Grundplatte (2) elektrisch isoliert sind.

6. Schaltungsvorrichtung (1) nach einem der vorhergehenden Ansprüche,
**dadurch gekennzeichnet, dass** die Grundplatte (2) wenigstens teilweise aus Metall, Keramik, Polymer oder Verbundwerkstoffen gefertigt ist.

7. Schaltungsvorrichtung (1) nach einem der vorhergehenden Ansprüche,
**dadurch gekennzeichnet, dass** das Mouldgehäuse (11) aus Polymeren und aus anorganischen Partikeln, die jeweils aus wenigstens einem Metalloxid und/oder Metallnitrid und/oder Metallcarbid und/oder Halbmetalloxid und/oder Halbmetallnitrid und/oder Halbmetallcarbid bestehen, gefertigt ist.

8. Schaltungsvorrichtung (1) nach einem der vorhergehenden Ansprüche,
**dadurch gekennzeichnet, dass** die Grundplatte (2) aus dem Mouldgehäuse (11) herausragt.

9. Schaltungsvorrichtung (1) nach einem der vorhergehenden Ansprüche, **gekennzeichnet durch** ein als ein Stanzgitter oder als flexible Leiterplatte oder als thermoplastische Leiterplatte ausgebildetes Kontaktierungselement (13).

10. Verfahren zur Herstellung einer Schaltungsvorrichtung (1) gemäß einem der vorhergehenden Ansprüche, wobei
- das erste Substrat (3) und das zweite Substrat (4) durch das wenigstens eine elektrische Verbindungselement (5) elektrisch miteinander verbunden werden,
- das erste Substrat (3) und/oder das zweite Substrat (4) elektrisch leitfähig mit dem wenigstens einen Kontaktierungselement (13) verbunden werden,
- auf oder in dem ersten Substrat (3) und auf oder in dem zweiten Substrat (4) jeweils wenigstens ein elektronisches Bauelement (9) angeordnet werden,
- das erste Substrat (3) an der ersten Außenseite (6) der Grundplatte (2) angeordnet wird und das zweite Substrat (4) an der zweiten Außenseite (7) der Grundplatte (2) angeordnet wird,
- und um die beiden Substrate (3, 4) und die auf ihnen angeordneten elektronischen Bauelemente (9) herum das Mouldgehäuse (11) gegossen wird.

## Claims

1. Circuit device (1) comprising
- a baseplate (2),
- a first substrate (3) arranged on a first outer side (6) of the baseplate (2),
- a second substrate (4) arranged on a second outer side (7)
- opposite the first outer side (6) of the baseplate (2),
- at least one electrical connection element (5) that electrically connects the first substrate (3) and the second substrate (4),
- at least one electronic component (9) arranged on or in the first substrate (3),
- at least one electronic component (9) arranged on or in the second substrate (4),
- a mold package (11) molded around the two substrates (3, 4) and the electronic components (9) arranged thereon,
- and at least one contacting element (13) for electrically contacting the first substrate (3) and/or second substrate (4), said at least one contacting element being electrically conductively connected to the first substrate (3) and/or the second substrate (4) and being passed out of the mold package (11),
**characterized in that**
- the mold package (11) is manufactured in the region of the first substrate (3) from a first material (11.1), the thermal expansion coefficient of which is matched to the thermal expansion coefficient of the first substrate (3), and in the region of the second substrate (4) from a second material (11.2), the thermal expansion coefficient of which is matched to the thermal expansion coefficient of the second substrate (4),
- and **in that** the baseplate (2) has at least three layers (2.1 to 2.5) of different thermal expansion coefficients arranged one above the other, wherein the first outer side (6) of the baseplate (2) is formed by an outer side of a first layer (2.1), and the second outer side (7) of the baseplate (2) is formed by an outer side of a second layer (2.2), and the thermal expansion coefficients of the at least three layers (2.1 to 2.5) decrease monotonically from the first layer (2.1) to the second layer (2.2), when the thermal expansion coefficient of the first substrate (3) is greater than the thermal expansion coefficient of the second substrate (4), or increase monotonically, when the thermal expansion coefficient of the first substrate (3) is less than the thermal expansion coefficient of the second substrate (4) and wherein the thermal expansion coefficient of the first layer (2.1) coincides with the thermal expansion coefficient of the first substrate (3), and the thermal expansion coefficient of the second layer (2.2) coincides with the thermal expansion coefficient of the second substrate (4).

2. Circuit device (1) according to Claim 1,
**characterized in that** at least one of the two substrates (3, 4) is designed as a microelectronic module, which is built up on a bare die high density interconnect circuit board or a ceramic substrate or a low temperature co-fired ceramic substrate or a high temperature multilayer ceramic substrate, or is designed as a power electronics module.

3. Circuit device (1) according to one of the preceding claims,
**characterized by** an electrical connection element (5) designed as a bonding wire, a flexible circuit board, a temperature-stable thermoplastic circuit board or a stamped grid.

4. Circuit device (1) according to one of the preceding claims,
**characterized in that** at least one substrate (3, 4) is secured on the baseplate (2) by adhesive bonding or lamination.

5. Circuit device (1) according to one of the preceding claims,
**characterized in that** both substrates (3, 4) are electrically insulated from the baseplate (2).

6. Circuit device (1) according to one of the preceding claims,
**characterized in that** the baseplate (2) is manufactured at least partially from metal, ceramics, polymers or composite materials.

7. Circuit device (1) according to one of the preceding claims,
**characterized in that** the mold package (11) is manufactured from polymers and from inorganic particles, which are each composed of at least one metal oxide and/or metal nitride and/or metal carbide and/or semimetal oxide and/or semimetal nitride and/or semimetal carbide.

8. Circuit device (1) according to one of the preceding claims,
**characterized in that** the baseplate (2) protrudes from the mold package (11).

9. Circuit device (1) according to one of the preceding claims,
**characterized by** a contacting element (13) designed as a stamped grid or as a flexible circuit board or as a thermoplastic circuit board.

10. Method for producing a circuit device (1) according to one of the preceding claims, wherein
- the first substrate (3) and the second substrate (4) are connected electrically to one another by the at least one electrical connection element (5),
- the first substrate (3) and/or the second substrate (4) are connected electrically conductively to the at least one contacting element (13),
- at least one electronic component (9) is in each case arranged on or in the first substrate (3) and on or in the second substrate (4),
- the first substrate (3) is arranged on the first outer side (6) of the baseplate (2) and the second substrate (4) is arranged on the second outer side (7) of the baseplate (2),
- and the mold package (11) is molded around both the substrates (3, 4) and around the electronic components (9) arranged thereon.

## Revendications

1. Dispositif à circuit (1) comprenant
- une plaque de base (2),
- un premier substrat (3) disposé sur un premier côté extérieur (6) de la plaque de base (2),
- un deuxième substrat (4) disposé sur un deuxième côté extérieur (7) de la plaque de base (2), opposé au premier côté extérieur (6),
- au moins un élément de liaison électrique (5) qui relie électriquement le premier substrat (3) et le deuxième substrat (4),
- au moins un composant électronique (9) disposé sur ou dans le premier substrat (3),
- au moins un composant électronique (9) disposé sur ou dans le deuxième substrat (4),
- un boîtier de moulage (11) surmoulé autour des deux substrats (3, 4) et des composants électroniques (9) disposés sur ceux-ci,
- et au moins un élément d'établissement de contact (13), relié de manière électriquement conductrice au premier substrat (3) et/ou au deuxième substrat (4) et sortant hors du boîtier de moulage (11), destiné à établir un contact électrique avec le premier substrat (3) et/ou le deuxième substrat (4),
**caractérisé en ce que**
- le boîtier de moulage (11) est fabriqué, dans la zone du premier substrat (3), à partir d'un matériau (11.1) dont le coefficient de dilatation thermique est adapté au coefficient de dilatation thermique du premier substrat (3) et, dans la zone du deuxième substrat (4), à partir d'un matériau (11.2) dont le coefficient de dilatation thermique est adapté au coefficient de dilatation thermique du deuxième substrat (4),
- et **en ce que** la plaque de base (2) possède au moins trois couches (2.1 à 2.5) disposées les unes au-dessus des autres ayant des coefficients de dilatation thermique différents, le premier côté extérieur (6) de la plaque de base (2) étant formé par un côté extérieur d'une première couche (2.1) et le deuxième côté extérieur (7) de la plaque de base (2) étant formé par un côté extérieur d'une deuxième couche (2.2) et les coefficients de dilatation thermique des au moins trois couches (2.1 à 2.5) diminuant de manière monotone de la première couche (2.1) à la deuxième couche (2.2) lorsque le coefficient de dilatation thermique du premier substrat (3) est supérieur au coefficient de dilatation thermique du deuxième substrat (4) ou augmentant de manière monotone lorsque le coefficient de dilatation thermique du premier substrat (3) est inférieur au coefficient de dilatation thermique du deuxième substrat (4), et le coefficient de dilatation thermique de la première couche (2.1) coïncidant avec le coefficient de dilatation thermique du premier substrat (3) et le coefficient de dilatation thermique de la deuxième couche (2.2) coïncidant avec le coefficient de dilatation thermique du deuxième substrat (4).

2. Dispositif à circuit (1) selon la revendication 1, **caractérisé en ce qu'**au moins l'un des deux substrats (3, 4) est réalisé sous la forme d'un module microélectronique qui est construit sur un circuit imprimé d'interconnexion à haute densité à puces nues ou un substrat en céramique ou un substrat en céramique cofritté à basse température ou un substrat en céramique multicouche à haute température, ou sous la forme d'un module électronique de puissance.

3. Dispositif à circuit (1) selon l'une des revendications précédentes, **caractérisé par** un élément de liaison électrique (5) réalisé sous la forme d'un fil de connexion, d'un circuit imprimé souple, d'un circuit imprimé thermoplastique résistant à la température ou d'une grille de connexion.

4. Dispositif à circuit (1) selon l'une des revendications précédentes, **caractérisé en ce qu'**au moins un substrat (3, 4) est fixé à la plaque de base (2) par collage ou stratification.

5. Dispositif à circuit (1) selon l'une des revendications précédentes, **caractérisé en ce que** les deux substrats (3, 4) sont isolés électriquement par rapport à la plaque de base (2).

6. Dispositif à circuit (1) selon l'une des revendications précédentes, **caractérisé en ce que** la plaque de base (2) est au moins partiellement fabriquée à partir de métal, de céramique, de polymère ou de matériaux composites.

7. Dispositif à circuit (1) selon l'une des revendications précédentes, **caractérisé en ce que** le boîtier de moulage (11) est fabriqué à partir de polymères et à partir de particules anorganiques, qui se composent respectivement d'au moins un oxyde métallique et/ou nitrure métallique et/ou carbure métallique et/ou oxyde de métalloïde et/ou nitrure de métalloïde et/ou carbure de métalloïde.

8. Dispositif à circuit (1) selon l'une des revendications précédentes, **caractérisé en ce que** la plaque de base (2) fait saillie hors du boîtier de moulage (11).

9. Dispositif à circuit (1) selon l'une des revendications précédentes, **caractérisé par** un élément d'établissement de contact (13) réalisé sous la forme d'une grille de connexion ou d'un circuit imprimé souple ou d'un circuit imprimé thermoplastique.

10. Procédé de fabrication d'un dispositif à circuit (1) selon l'une des revendications précédentes, dans lequel
- le premier substrat (3) et le deuxième substrat (4) sont reliés électriquement l'un à l'autre par l'au moins un élément de liaison électrique (5),
- le premier substrat (3) et/ou le deuxième substrat (4) sont reliés de manière électriquement conductrice à l'au moins un élément d'établissement de contact (13),
- au moins un composant électronique (9) est respectivement disposé sur ou dans le premier substrat (3) et sur ou dans le deuxième substrat (4),
- le premier substrat (3) est disposé sur le premier côté extérieur (6) de la plaque de base (2) et le deuxième substrat (4) est disposé sur le deuxième côté extérieur (7) de la plaque de base (2),
- et un boîtier de moulage (11) est surmoulé autour des deux substrats (3, 4) et des composants électroniques (9) disposés sur ceux-ci.
